(19)

Europäisches
Patentamt
European
Patent Office
Office européen
des brevets

(11) **EP 3 683 541 A1**

(12) **EUROPEAN PATENT APPLICATION**
published in accordance with Art. 153(4) EPC

(43) Date of publication:
**22.07.2020 Bulletin 2020/30**

(21) Application number: **19870065.0**

(22) Date of filing: **01.03.2019**

(51) Int Cl.:
*G01C 1/00* (2006.01)      *G01R 29/10* (2006.01)
*G01B 9/10* (2006.01)      *G06T 7/00* (2017.01)

(86) International application number:
**PCT/CN2019/076720**

(87) International publication number:
**WO 2020/098177 (22.05.2020 Gazette 2020/21)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **15.11.2018 CN 201811363450**

(71) Applicant: **Wuyi University**
**Jiangmen, Guangdong 529000 (CN)**

(72) Inventor: **The designation of the inventor has not
yet been filed**

(74) Representative: **Juncosa Miró, Jaime
Torner, Juncosa i Associats, S.L.
Gran Via de les Corts
Catalanes, 669 bis, 1o, 2a
08013 Barcelona (ES)**

(54) **METHOD FOR MEASURING DOWNWARD INCLINATION ANGLE OF ANTENNA BASED ON
LINEAR REGRESSION FITTING**

(57)      The present disclosure discloses a method for measuring an antenna downtilt based on linear regression fitting, including: performing image instance segmentation on an inputted original antenna image using a deep learning method to obtain a segmented image; performing mask processing on the segmented image; performing mathematically linear modeling and fitting on the segmented image subjected to mask processing; and the performing mathematically linear modeling and fitting on the segmented image subjected to mask processing including: extracting pixel value coordinates of an antenna edge contour from the segmented image subjected to mask processing, and capturing a pixel value of a right-end edge of the antenna; and fitting the pixel value coordinates into a straight line by using a mathematically linear modeling and fitting method to obtain an angle of the antenna downtilt. The angle of the antenna downtilt is obtained based on a deep learning network of an image of an antenna with reference to masking and linear fitting to establish a convenient, safe, efficient and accurate antenna measurement method.

**Fig.1**

EP 3 683 541 A1

**EP 3 683 541 A1**

**Description**

**TECHNICAL FIELD**

The present disclosure relates to the field of communication measurement, and more particularly, to a method for measuring an antenna downtilt based on linear regression fitting.

**BACKGROUND**

In the field of communications, an antenna downtilt needs to be adjusted frequently. As one of the important parameters determining a coverage area of signals of base stations, the antenna downtilt needs to be accurately designed in the initial stage of network planning. Furthermore, after the base stations are put into operation, with the development of services and changes of users and surrounding signal environments, it is also required to accurately adjust the downtilt.

At present, a slope meter is generally used to measure a mechanical downtilt of an antenna of a base station. When measuring the mechanical downtilt of the antenna using the slope meter, a measurer need to climb up an iron tower or hold a pole to get close to the antenna to measure, which is not only dangerous and troublesome, but also affects the accuracy of the measurement. With the development of technologies, a GSM-R system has emerged. The system is a measurement tool allowing the measurer to accurately measure the antenna downtilt without getting close to the antenna, the measurement of the antenna downtilt of the base station could be carried out without climbing up a tower, test points of the base station could be networked to monitor the downtilt of the base station in real-time. However, installation of sensors is time-consuming and is high in cost. Moreover, there exist differences between new towers and old towers, the number of towers of base stations and the number of the base stations, etc. Therefore, this method is of low practicability, long operational cycle, and difficult to be implemented. Therefore, it is necessary to design an angle measurement method which is simple in operation and reliable in performance.

**SUMMARY**

To solve the above problems, an objective of embodiments of the present disclosure is to provide a method for measuring an antenna downtilt based on linear regression fitting, so as to safely, efficiently, quickly and accurately measure an antenna downtilt.

In order to solve the above problems, the embodiments of the present disclosure adopt following technical solution.

A method for measuring an antenna downtilt based on linear regression fitting includes: performing image instance segmentation on an inputted original antenna image using a deep learning method to obtain a segmented image; performing mask processing on the segmented image; performing mathematically linear modeling and fitting on the segmented image subjected to mask processing; and the performing mathematically linear modeling and fitting on the segmented image subjected to mask processing includes: extracting pixel value coordinates of an antenna edge contour from the segmented image subjected to mask processing, and capturing a pixel value of a right-end edge on an antenna plane located in a front side; and fitting the pixel value coordinates into a straight line by using a mathematically linear modeling and fitting method and obtaining a slope of the straight line to obtain an angle of the antenna downtilt.

Further, the performing image instance segmentation on an inputted antenna image using a deep learning method to obtain a segmented image includes: obtaining an antenna candidate box and an antenna characteristic diagram by using a convolutional neural network; and generating a region of interest from the antenna candidate box and obtaining a characteristic diagram of the region of interest with reference to the antenna characteristic diagram to perform pixel correction on the region of interest.

Further, the performing image instance segmentation on an inputted antenna image using a deep learning method to obtain a segmented image further includes: predicting the region of interest, to obtain a regression bounding box mapped from the antenna characteristic diagram, and predicting a class of a pixel in the region of interest to obtain the segmented image.

Further, the pixel correction is performing alignment processing by using a residual network; and the pixel correction includes two quantization processes, which are mapping from the region of interest to the antenna characteristic diagram and mapping from the antenna characteristic diagram to the original antenna image respectively.

Further, the performing mask processing on the segmented image includes: extracting image coordinates of a contour of the antenna from the segmented image; mapping the image coordinates to a pixel coordinate system, and transforming into binarization coordinates through Bohr operation, convoluting with mask coordinates set to generate a new mask; and filling up the new mask by using a color generator.

Further, the mapping the image coordinates to a pixel coordinate system includes transforming the coordinates system.

To solve the above problems, an objective of embodiments of the present disclosure is to provide a method for measuring an antenna downtilt based on linear regression fitting, so as to safely, efficiently, quickly and accurately measure an antenna downtilt.

In order to solve the above problems, the embodiments of the present disclosure adopt following technical solution.

A method for measuring an antenna downtilt based on linear regression fitting includes: performing image instance segmentation on an inputted original antenna image using a deep learning method to obtain a segmented image; performing mask processing on the segmented image; performing mathematically linear modeling and fitting on the segmented image subjected to mask processing; and the performing mathematically linear modeling and fitting on the segmented image subjected to mask processing includes: extracting pixel value coordinates of an antenna edge contour from the segmented image subjected to mask processing, and capturing a pixel value of a right-end edge on an antenna plane located in a front side; and fitting the pixel value coordinates into a straight line by using a mathematically linear modeling and fitting method and obtaining a slope of the straight line to obtain an angle of the antenna downtilt.

Further, the performing image instance segmentation on an inputted antenna image using a deep learning method to obtain a segmented image includes: obtaining an antenna candidate box and an antenna characteristic diagram by using a convolutional neural network; and generating a region of interest from the antenna candidate box and obtaining a characteristic diagram of the region of interest with reference to the antenna characteristic diagram to perform pixel correction on the region of interest.

Further, the performing image instance segmentation on an inputted antenna image using a deep learning method to obtain a segmented image further includes: predicting the region of interest, to obtain a regression bounding box mapped from the antenna characteristic diagram, and predicting a class of a pixel in the region of interest to obtain the segmented image.

Further, the pixel correction is performing alignment processing by using a residual network; and the pixel correction includes two quantization processes, which are mapping from the region of interest to the antenna characteristic diagram and mapping from the antenna characteristic diagram to the original antenna image respectively.

Further, the performing mask processing on the segmented image includes: extracting image coordinates of a contour of the antenna from the segmented image; mapping the image coordinates to a pixel coordinate system, and transforming into binarization coordinates through Bohr operation, convoluting with mask coordinates set to generate a new mask; and filling up the new mask by using a color generator.

Further, the mapping the image coordinates to a pixel coordinate system includes transforming the coordinates system.

2

Preferably, an operation formula for generating the new mask is as below:
$I(i, j)=5*I(i, j)-[I (i-1, j)+I(i+1, j)+I(i, j-1)+I(i, j+1)]$; wherein $I(i, j)$ represents an image center element.

Further, the mathematically linear modeling and fitting include implementing optimization of a data sample by using a gradient descent least square method.

Preferably, a model for fitting the straight line is $f(x)=w^T x+b$; wherein $w^T$ represents a transpose of a weight matrix, and $b$ represents an offset; and a formula for calculating the antenna downtilt is $\theta=\arctan(|k|)$; wherein k represents the slope of the straight line fitted by the gradient descent least square method.

Beneficial effects of embodiments of the present disclosure are as below: The embodiments of the present disclosure adopt a method for measuring an antenna downtilt based on linear regression fitting. An angle of the antenna downtilt is directly outputted and obtained after being processed by a deep learning network. Meanwhile, a segmented image obtained through mask instance segmentation allows a straight line obtained by mathematically linear modeling to be more fit to a true value of the antenna, ensuring the angle of the antenna downtilt to be more accurate. The method provided by the embodiments of the present disclosure avoids the danger of climbing measurement and reduces costs of installation sensors, and can more efficiently, safely and accurately obtain data of an antenna downtilt at low cost.

## BRIEF DESCRIPTION OF THE DRAWINGS

The present disclosure is further described below with reference to the accompanying drawings and examples.

FIG. 1 is a structural diagram of a deep learning method for image instance segmentation according to an embodiment of the present disclosure;

FIG. 2 is a flow block diagram of image instance segmentation according to an embodiment of the present disclosure;

FIG. 3 is a schematic diagram of aligning a network of interest by using a residual network according to an embodiment of the present disclosure;

FIG. 4 is a schematic diagram showing a corresponding relationship between an image coordinate system and a pixel coordinate system according to an embodiment of the present disclosure;

FIG. 5 is an arithograph of mask operation according to an embodiment of the present disclosure; and

FIG. 6 is a coordinate graph of mathematically linear modeling and fitting according to an embodiment of the present disclosure.

## DETAILED DESCRIPTION

An embodiment of the present disclosure discloses a method for measuring an antenna downtilt based on linear regression fitting, including: performing image instance segmentation on an inputted original antenna image using a deep learning method to obtain a segmented image; performing mask processing on the segmented image; performing mathematically linear modeling and fitting on the segmented image subjected to mask processing; and the performing mathematically linear modeling and fitting on the segmented image subjected to mask processing including: extracting pixel value coordinates of an antenna edge contour from the segmented image subjected to mask processing, and capturing a pixel value of a right-end edge on an antenna plane located in a front side; and fitting the pixel value coordinates into a straight line by using a mathematically linear modeling and fitting method and obtaining a slope of the straight line to obtain an angle of the antenna downtilt.

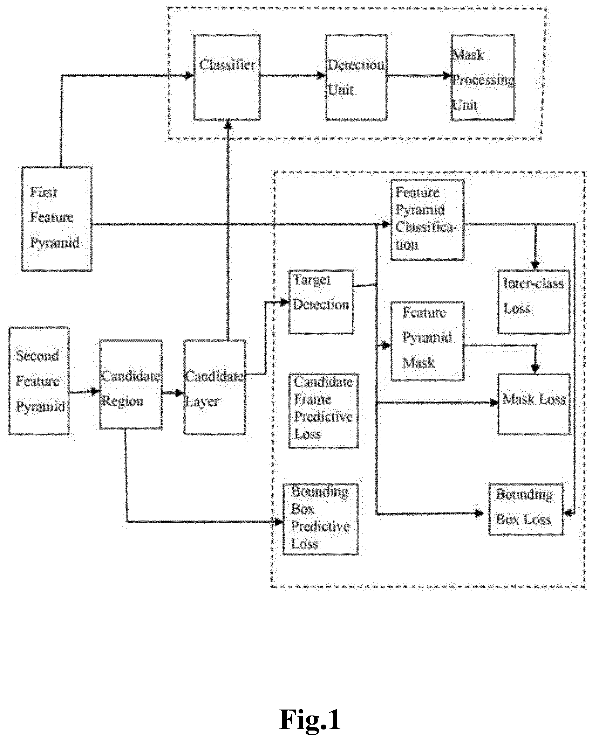

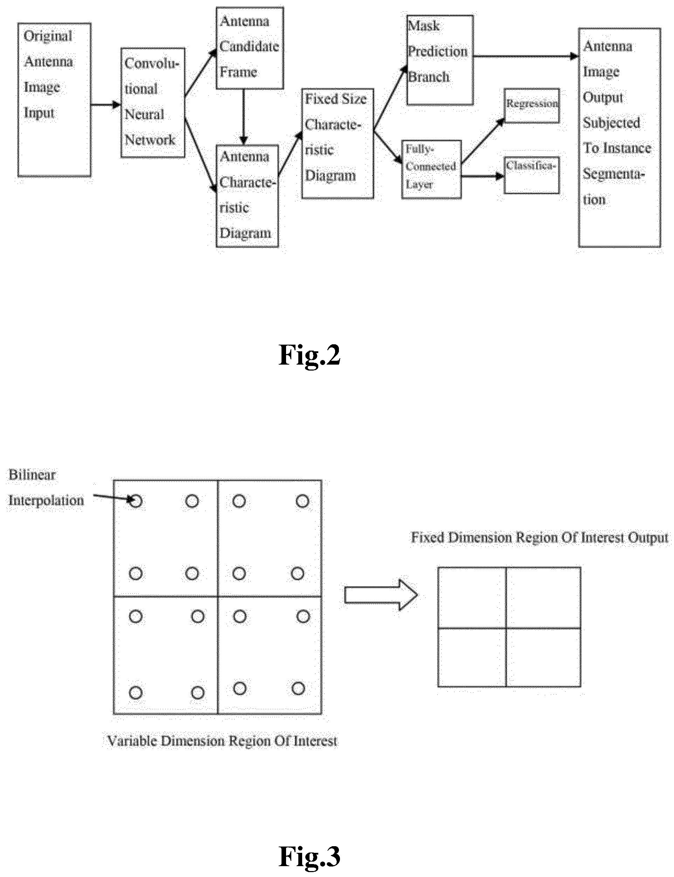

Referring to FIG. 1 and FIG. 2, in an embodiment, the performing image instance segmentation on an inputted antenna image using a deep learning method to obtain a segmented image includes: obtaining an antenna candidate box and an antenna characteristic diagram by using a convolutional neural network; and generating a region of interest from the antenna candidate box and obtaining a characteristic diagram of the region of interest with reference to the antenna characteristic diagram to perform pixel correction on the region of interest.

Further, the performing image instance segmentation on an inputted antenna image using a deep learning method to obtain a segmented image further includes: predicting the region of interest to obtain a regression bounding box mapped by the antenna characteristic diagram, and predicting a class of a pixel in the region of interest to obtain the segmented image.

Referring to FIG. 3, the pixel correction is performing alignment processing by using a residual network; and the pixel correction includes two quantization processes, which are a process of mapping from the region of interest to the antenna characteristic diagram and a process of mapping from the antenna characteristic diagram to the original antenna image respectively, ensuring one-to-one correspondence between input and output at the pixel level.

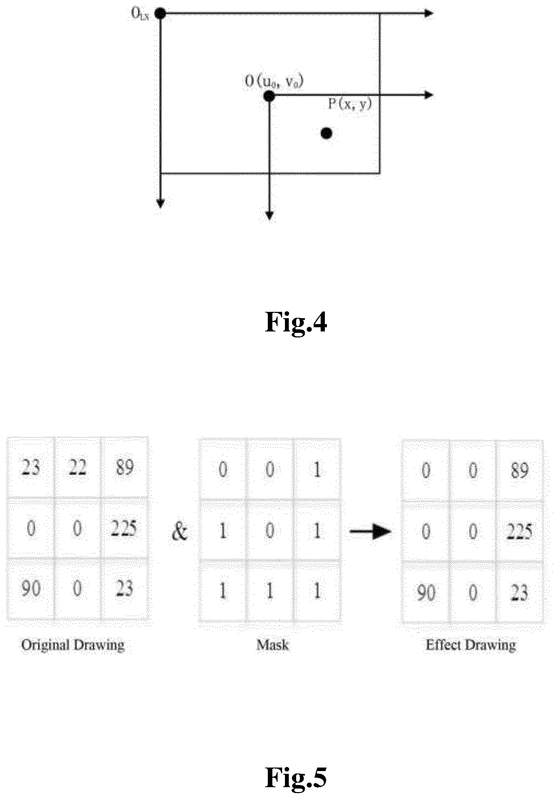

Referring to FIG. 5, in an embodiment, the performing mask processing on the segmented image include: extracting image coordinates of a contour of the antenna from the segmented image; mapping the image coordinates to a pixel coordinates system, and transforming into binarization coordinates through Bohr operation, convoluting with mask coordinates set to generate a new mask; and filling up the new mask by using a color generator.

Preferably, an operation formula for generating the new mask is as below:
$I(i, j)=5*I(i, j)-[I(i-1, j)+I(i+1, j)+I(i, j-1)+I(i, j+1)]$; wherein $I(i, j)$ represents an image center element.

Referring to FIG. 4, in an embodiment, the mapping the image coordinates to a pixel coordinates system includes transforming the coordinates system. The pixel coordinates system and the image coordinates system are both on an imaging plane of the antenna image, but their origins and measurement units are different. The origin of the image coordinate system is an intersection point of an optical axis of a camera and the imaging plane, which is a center point of the imaging plane generally. The unit of the image coordinate system is mm, and the unit of the pixel coordinate system is pixel. The transformation between the image coordinate system and the pixel coordinate system is as follows: wherein dx and dy represent how many "mm"s each column and each row respectively represent, that is, 1 pixel=dx mm. The coordinate transformation formula is as follows:

$$\begin{cases} u = \dfrac{x}{dx} + u_0 \\ v = \dfrac{y}{dy} + v_0 \end{cases} \Rightarrow \begin{bmatrix} u \\ v \\ 1 \end{bmatrix} = \begin{bmatrix} \dfrac{1}{dx} & 0 & u_0 \\ 0 & \dfrac{1}{dy} & v_0 \\ 0 & 0 & 1 \end{bmatrix} \begin{bmatrix} x \\ y \\ 1 \end{bmatrix}$$

$$z_c \begin{bmatrix} u \\ v \\ 1 \end{bmatrix} = \begin{bmatrix} \dfrac{1}{dx} & 0 & u_0 \\ 0 & \dfrac{1}{dy} & v_0 \\ 0 & 0 & 1 \end{bmatrix} \begin{bmatrix} f & 0 & 0 & 0 \\ 0 & f & 0 & 0 \\ 0 & 0 & 1 & 0 \end{bmatrix} \begin{bmatrix} R & T \\ 0 & 1 \end{bmatrix} \begin{bmatrix} X_W \\ Y_W \\ Z_W \\ 1 \end{bmatrix} = \begin{bmatrix} f_x & 0 & u_0 & 0 \\ 0 & f_y & v_0 & 0 \\ 0 & 0 & 1 & 0 \end{bmatrix} \begin{bmatrix} R & T \\ 0 & 1 \end{bmatrix} \begin{bmatrix} X_W \\ Y_W \\ Z_W \\ 1 \end{bmatrix};$$

wherein $u_0$ and $v_0$ respectively represent an abscissa and an ordinate of the center point of the image coordinate system; R represents a 3×3 orthogonal present matrix; and T represents a three-dimensional translation vector.

The segmented image needs to be masked by a mask branch network. As a convolutional network, the mask branch network takes a positive region selected by a region of interest classifier as input and generates a mask of the positive region. The generated mask corresponds to a low resolution of 28×28 pixels. As a soft mask represented by a floating point number, the generated mask has more details than a binary mask. The small size attribute of the mask contributes to keeping the light weight of the masked branch network. During the inference process, the predicted mask is enlarged to the size of a bounding box of the region of interest to provide final mask results.

Referring to FIG. 6, the mathematically linear modeling and fitting includes implementing optimization of a data sample by using a gradient descent least square method. Preferably, a model for fitting the straight line is $f(x)=w^Tx+b$; wherein $w^T$ represents a transpose of a weight matrix, and $b$ represents an offset; and a formula for calculating the antenna downtilt is $\theta=\arctan(|k|)$; wherein k represents the slope of the straight line fitted by the gradient descent least square method.

In one embodiment, the calculation process is as follows: yi represents a true value of the ith point; f(xi) represents a predicted value obtained after being processed by a model function f; and an expression of Euclidean distance is obtained as below: distance=$(yi-f(xi))^2$. From the perspective of a loss function, this formula is a square error, i.e., $J(\theta) = 1/2(Y-\theta X)^2$;

and a fitted objective function is obtained as:

$$\arg\min_{(w,b)} \sum_{i=1}^{m} \frac{1}{2}(Y - \theta X)^2 \quad ;$$

$J(\theta)$ is calculated through a vector operation:

$$J(\theta) = \arg\min_{(w,b)} \sum_{i=1}^{m} \frac{1}{2}(Y-\theta X)^2 = \frac{1}{2}(Y-\theta X)(Y-\theta X)$$

$$= \frac{1}{2}(\theta^T X^T X \theta - \theta^T X^T Y - Y^T X \theta - Y^T Y)$$

;

A partial derivative calculation is performed on $\theta$:

$$\frac{\partial J(\theta)}{\partial \theta} = \frac{1}{2}(2X^T X \theta - 2X^T Y) = (X^T X \theta - X^T Y)$$

;

By making the partial derivative be equal to zero and fitting the sample points onto an approximate straight line, the slope of the straight line may be obtained by least square error, and then the downtilt of an antenna of a base station is accurately obtained. As can be seen from the following arc tangent formula: $\theta$=arctan(|k|), wherein $\theta$ represents the antenna downtilt, and k represents the slope of the straight line fitted by the gradient descent least square method.

The above descriptions are merely preferred embodiments of the present disclosure, but the present disclosure is not limited to the above embodiments. Any embodiment should fall within the protection scope of the present disclosure as long as it achieves the technical effects of the present disclosure by the same means.

## Claims

1. A method for measuring an antenna downtilt based on linear regression fitting, comprising:

    performing image instance segmentation on an inputted original antenna image using a deep learning method to obtain a segmented image;
    performing mask processing on the segmented image;
    performing mathematically linear modeling and fitting on the segmented image subjected to mask processing; and
    the performing mathematically linear modeling and fitting on the segmented image subjected to mask processing comprising: extracting pixel value coordinates of an antenna edge contour from the segmented image subjected to mask processing, and capturing a pixel value of a right-end edge on an antenna plane located in a front side; and fitting the pixel value coordinates into a straight line by using a mathematically linear modeling and fitting method and obtaining a slope of the straight line to obtain an angle of the antenna downtilt.

2. The method for measuring an antenna downtilt based on linear regression fitting according to claim 1, wherein the performing image instance segmentation on an inputted antenna image using a deep learning method to obtain a segmented image comprises:

    obtaining an antenna candidate box and an antenna characteristic diagram by using a convolutional neural network; and
    generating a region of interest from the antenna candidate box and obtaining a characteristic diagram of the region of interest with reference to the antenna characteristic diagram to perform pixel correction on the region of interest.

3. The method for measuring an antenna downtilt based on linear regression fitting according to claim 2, wherein the performing image instance segmentation on an inputted antenna image using a deep learning method to obtain a segmented image further comprises: predicting the region of interest to obtain a regression bounding box mapped from the antenna characteristic diagram, and predicting a class of a pixel in the region of interest to obtain the segmented image.

4. The method for measuring an antenna downtilt based on linear regression fitting according to any one of claims 2 to 3, wherein the pixel correction is performing alignment processing by using a residual network; and the pixel correction comprises two quantization processes, which are mapping from the region of interest to the antenna characteristic diagram and mapping from the antenna characteristic diagram to the original antenna image respectively.

5. The method for measuring an antenna downtilt based on linear regression fitting according to claim 1, wherein the performing mask processing on the segmented image comprises: extracting image coordinates of a contour of the antenna from the segmented image; mapping the image coordinates to a pixel coordinate system, and transforming the into binarization coordinates through Bohr operation, convoluting with mask coordinate set to generate a new mask; and filling up the new mask by using a color generator.

6. The method for measuring an antenna downtilt based on linear regression fitting according to claim 5, wherein the mapping the image coordinates to a pixel coordinate system comprises transforming the coordinate system.

7. The method for measuring an antenna downtilt based on linear regression fitting according to claim 5, wherein generating the new mask is performed according to an operation formula:
$I(i, j)=5*I(i, j)-[I(i-1, j)+I(i+1, j)+I(i, j-1)+I(i, j+1)]$; wherein $I(i, j)$ represents an image center element.

8. The method for measuring an antenna downtilt based on linear regression fitting according to claim 1, wherein the mathematically linear modeling and fitting comprise implementing optimization of a data sample by using a gradient descent least square method.

9. The method for measuring an antenna downtilt based on linear regression fitting according to claim 8, wherein the straight line is fit according to a model: $f(x)=w^T x+b$; wherein $w^T$ represents a transpose of a weight matrix, and $b$ represents an offset; and a formula for calculating the antenna downtilt is:
$\theta=arctan(|k|)$; wherein k represents the slope of the straight line fitted by the gradient descent least square method.

**Fig.1**

EP 3 683 541 A1

**Fig.2**

Bilinear Interpolation

Fixed Dimension Region Of Interest Output

Variable Dimension Region Of Interest

**Fig.3**

8

**Fig.4**

Original Drawing     Mask     Effect Drawing

**Fig.5**

## INTERNATIONAL SEARCH REPORT

| International application No. |
|---|
| **PCT/CN2019/076720** |

**A. CLASSIFICATION OF SUBJECT MATTER**

G01C 1/00(2006.01)i; G01R 29/10(2006.01)i; G01B 9/10(2006.01)i; G06T 7/00(2017.01)i

According to International Patent Classification (IPC) or to both national classification and IPC

**B. FIELDS SEARCHED**

Minimum documentation searched (classification system followed by classification symbols)

G01C; G01R; G01B; G06T

Documentation searched other than minimum documentation to the extent that such documents are included in the fields searched

Electronic data base consulted during the international search (name of data base and, where practicable, search terms used)

CNABS; CNTXT; CNKI; 万方, WANFANG; 超星, SUPERSTAR; VEN; USTXT; EPTXT; IEEE: 邓文博, 翟懿奎, 柯琪锐, 伍月婷, 甘俊英, 徐颖, 王天雷, 吴细, 陈丽燕, 五邑大学, 掩膜, 掩模, 颜色, 拟合, 坐标, 分割, 边缘, 图像, 神经网络, 倾角, 角度, 姿态, 线性回归, antenna, angle, measure, mask, pixel, image, edge, linear regression

**C. DOCUMENTS CONSIDERED TO BE RELEVANT**

| Category* | Citation of document, with indication, where appropriate, of the relevant passages | Relevant to claim No. |
|---|---|---|
| A | CN 105761249 A (NANJING INSTITUTE OF TECHNOLOGY) 13 July 2016 (2016-07-13) description, paragraphs [0027]-[0033] | 1-9 |
| A | CN 107830846 A (HANGZHOU AIHANG TECHNOLOGY CO., LTD.) 23 March 2018 (2018-03-23) entire document | 1-9 |
| A | CN 107121125 A (HARBIN INSTITUTE OF TECHNOLOGY) 01 September 2017 (2017-09-01) entire document | 1-9 |
| A | US 4758840 A (CENTRE NATIONAL D'ETUDES SPATIALES) 19 July 1988 (1988-07-19) entire document | 1-9 |

☐ Further documents are listed in the continuation of Box C.    ☑ See patent family annex.

| | |
|---|---|
| * Special categories of cited documents: <br> "A" document defining the general state of the art which is not considered to be of particular relevance <br> "D" document cited by the applicant in the international application <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| **04 July 2019** | **31 July 2019** |

| Name and mailing address of the ISA/CN <br><br> **China National Intellectual Property Administration (ISA/ CN)** <br> **No. 6, Xitucheng Road, Jimenqiao Haidian District, Beijing 100088** <br> **China** | Authorized officer |
|---|---|
| Facsimile No. **(86-10)62019451** | Telephone No. |

Form PCT/ISA/210 (second sheet) (January 2015)

**INTERNATIONAL SEARCH REPORT**
**Information on patent family members**

International application No.

**PCT/CN2019/076720**

| Patent document cited in search report | | | Publication date (day/month/year) | Patent family member(s) | | | Publication date (day/month/year) |
|---|---|---|---|---|---|---|---|
| CN | 105761249 | A | 13 July 2016 | CN | 105761249 | B | 15 June 2018 |
| CN | 107830846 | A | 23 March 2018 | None | | | |
| CN | 107121125 | A | 01 September 2017 | CN | 107121125 | B | 14 May 2019 |
| US | 4758840 | A | 19 July 1988 | EP | 0237433 | B1 | 19 September 1990 |
| | | | | JP | S62219803 | A | 28 September 1987 |
| | | | | FR | 2595872 | A1 | 18 September 1987 |
| | | | | EP | 0237433 | A1 | 16 September 1987 |
| | | | | DE | 3764982 | D1 | 25 October 1990 |
| | | | | ES | 2017727 | B | 01 March 1991 |

Form PCT/ISA/210 (patent family annex) (January 2015)